# EUROPEAN PATENT APPLICATION

(11) **EP 4 770 399 A1**
(43) Date of publication of application: **01.07.2026**
(21) Application number: 24902798.8
(22) Date of filing: 10.12.2024
(51) Int. Cl.: H10K 85/60

(54) **SOLAR CELL, INTERFACE PASSIVATION MATERIAL, PHOTOVOLTAIC POWER GENERATION SYSTEM AND ELECTRIC DEVICE**

(30) Priority: 13.12.2023 CN 202311716993
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: JIA, Boyu, Shanghai 200241 (CN); YIN, Zhaoyi, Shanghai 200241 (CN); LI, Pengli, Shanghai 200241 (CN); LIU, Jialing, Shanghai 200241 (CN); LIU, Tianyu, Shanghai 200241 (CN); GU, Shuai, Shanghai 200241 (CN); MENG, Ke, Shanghai 200241 (CN); CHEN, Junchao, Shanghai 200241 (CN); GUO, Yongsheng, Shanghai 200241 (CN)
(74) Representative: Gong, Jinping
(86) International application number: PCT/CN2024/138133
(87) International publication number: WO 2025/124377

(57) **Abstract**

The present application discloses a solar cell, an interface passivation material, a photovoltaic power generation system, and an electric device. The solar cell includes an interface passivation material, the interface passivation material including a first compound represented by chemical formula (1) and/or a second compound represented by chemical formula (2): 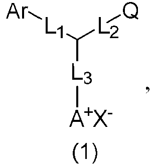 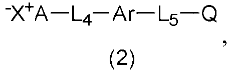 where Ar is an aromatic group, Q is a functional group containing active hydrogen, A⁺ is selected from an ammonium group or a phosphonium group, X⁻ is selected from any one of a halogen ion, a pseudohalogen ion, an oxyanion ion, a fluorine-containing borate ion, or a sulfonyl imide anion. The interface passivation material can be used in solar cells to passivate interface defects in the light absorption layer, improve carrier transport performance, and improve the photoelectric conversion efficiency and stability of the solar cell.

## Description

### CROSS-REFERENCE TO RELATED APPLICATIONS

The present application claims priority to Chinese Patent Application No. 202311716993.8, filed on December 13, 2023, and entitled "INTERFACE PASSIVATION MATERIAL, SOLAR CELL, PHOTOVOLTAIC POWER GENERATION SYSTEM, AND ELECTRIC DEVICE", which is incorporated herein by reference in its entirety.

### TECHNICAL FIELD

The present application relates to the field of new energy technologies, and in particular, to a solar cell, an interface passivation material, a photovoltaic power generation system, and an electric device.

### BACKGROUND

Solar cells, as an important technology in the field of new energy technologies, have expanded from military and aerospace applications to various fields such as industry, commerce, agriculture, communications, household appliances, and public facilities. Perovskite solar cells are among the most promising and potential solar cells, characterized by high efficiency, environmental friendliness, and low cost.

However, the photoelectric conversion efficiency of perovskite solar cells is currently far below the theoretical limit, and its stability does not meet usage standards, which is caused by high-density defects at the perovskite interface. The description herein merely provides background information related to the present application and does not necessarily constitute prior art.

### SUMMARY

The main technical problem addressed by the present application is to provide a solar cell, an interface passivation material, a photovoltaic power generation system, and an electric device capable of passivating interface defects in a light absorption layer, thereby improving the photoelectric conversion efficiency and stability of the solar cell.

To address the above technical problem, one technical solution adopted by the present application is to provide a solar cell. The solar cell includes an interface passivation material, the interface passivation material including a first compound represented by chemical formula (1) and/or a second compound represented by chemical formula (2): 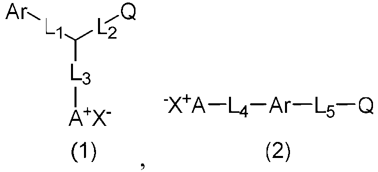 where, Ar is an aromatic group; Q is a functional group containing active hydrogen; A⁺ is selected from an ammonium group or a phosphonium group; X⁻ is selected from any one of a halogen ion, a pseudohalogen ion, an oxyanion ion, a fluoroanion ion, or a sulfonyl imide anion; L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, where the heteroatom includes one or more of a nitrogen atom, an oxygen atom, or a sulfur atom, and an alkylene chain with 0 carbon atoms indicates that the two groups connected to L1 to L5 are directly connected. The above interface passivation material can passivate defects at an interface of the perovskite layer, induce ordered stacking at the interface of the adjacent carrier transport layer, and block the migration of anions in perovskite, thereby improving the carrier transport performance and improving the photoelectric conversion efficiency and stability of a solar cell device.

In one embodiment, Q is selected from any one of a hydroxyl group (-OH), a carboxyl group (-COOH), a sulfhydryl group (-SH), an amino (-NR'H), or an amide group (-NHCOR); R' is selected from any one of a hydrogen atom, an alkyl chain with 1 to 10 carbon atoms, or a halogen-substituted alkyl chain with 1 to 10 carbon atoms; R is selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, where the heteroatom includes one or more of a nitrogen atom, an oxygen atom, or a sulfur atom. The functional group (Q) containing active hydrogen can provide active hydrogen to interact with strongly electronegative groups in the adjacent carrier transport layer, and can also induce ordered stacking at the interface of the adjacent carrier transport layer, thereby improving carrier transport performance.

In one embodiment, in the first compound, Ar includes any one of the following structures Ar1 to Ar15: 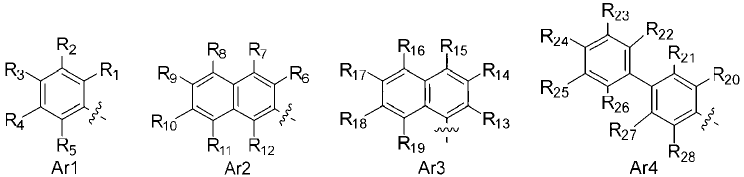 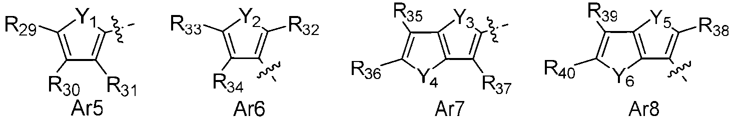 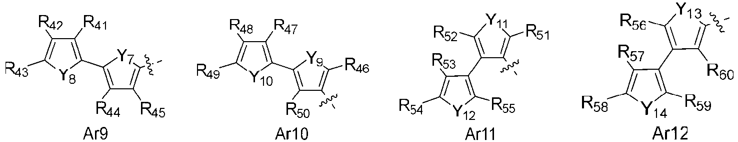 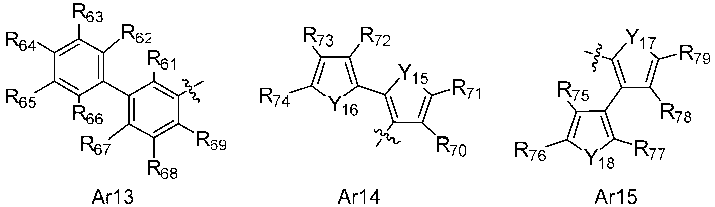
where, Y1 to Y18 are selected from any one of an oxygen atom (-O-), a sulfur atom (-S-), or an R'-substituted nitrogen atom (-NR'-); R' is selected from any one of a hydrogen atom, an alkyl chain with 1 to 10 carbon atoms, or a halogen-substituted alkyl chain with 1 to 10 carbon atoms; and R1 to R79 are selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, where the heteroatom includes one or more of a nitrogen atom, an oxygen atom, or a sulfur atom;
where, 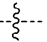 represents a single-bond attachment site, and when a structure of the interface passivation material is formula (1), the structures Ar1 to Ar15 are connected to L1 through 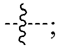 and/or
in the second compound, Ar includes any one of the following structures Ar16 to Ar30:
where, Ar16 differs from Ar1 in that any one of R1 to R5 is replaced by 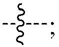 Ar17 differs from Ar2 in that any one of R6 to R12 is replaced by 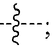 Ar18 differs from Ar3 in that any one of R13 to R19 is replaced by 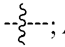 Ar19 differs from Ar4 in that any one of R20 to R28 is replaced by 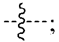 Ar20 differs from Ar5 in that any one of R29 to R31 is replaced by 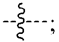 Ar21 differs from Ar6 in that any one of R32 to R34 is replaced by 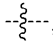 Ar22 differs from Ar7 in that any one of R35 to R37 is replaced by 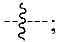 Ar23 differs from Ar8 in that any one of R38 to R40 is replaced by 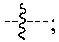 Ar24 differs from Ar9 in that any one of R41 to R45 is replaced by 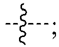 Ar25 differs from Ar10 in that any one of R46 to R50 is replaced by 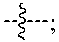 Ar26 differs from Ar11 in that any one of R51 to R55 is replaced by 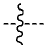 ; Ar27 differs from Ar12 in that any one of R56 to R60 is replaced by 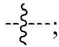 Ar28 differs from Ar 13 in that any one of R61 to R69 is replaced by 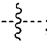 ; Ar29 differs from Ar14 in that any one of R70 to R74 is replaced by 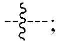 and Ar30 differs from Ar15 in that any one of R75 to R79 is replaced by

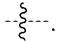

When the structure of the interface passivation material is formula (2), the structures Ar16 to Ar30 are connected to L4 and L5, respectively, through

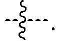

The aromatic group (Ar) can accumulate at the interface of the perovskite layer, blocking the migration of anions in the perovskite layer, thereby improving the stability of a perovskite solar cell. In addition, Ar can also induce the stacking of organic fused-ring molecules in the adjacent carrier transport layer, making its arrangement more ordered, thereby improving carrier transport performance.

In one embodiment, the ammonium group includes -NR'₃⁺; and/or the phosphonium group includes -PR'₃⁺, where R' is selected from any one of a hydrogen atom, an alkyl chain with 1 to 10 carbon atoms, or a halogen-substituted alkyl chain with 1 to 10 carbon atoms. The ammonium group and phosphonium group are cationic functional groups, so A⁺ can passivate A-site defects at the interface of the perovskite layer, stabilize the lattice, and reduce non-radiative recombination losses of carriers at the interface.

In one embodiment, the halogen ion includes any one of F⁻, Cl⁻, Br⁻, I;⁻ the pseudohalogen ion includes any one of CN⁻, OCN⁻, SCN⁻ the oxyanion ion includes any one of NO₃⁻, ClO₃⁻, R"SO₃⁻, R"COO⁻, or R"PO₂(OH)⁻, where R" is selected from any one of a hydrogen atom, an alkyl chain with 1 to 10 carbon atoms, a halogen-substituted alkyl chain with 1 to 10 carbon atoms, Ar1 to Ar15, or an alkyl chain with 1 to 10 carbon atoms substituted with Arl to Ar15; the fluoroanion ion includes any one of BF₄⁻, PF₆⁻; and/or the sulfonyl imide anion includes (CF₃SO₂)₂N⁻. The above X⁻ anions can effectively passivate iodine vacancy defects in the perovskite layer or coordinate with under-coordinated lead ions, reducing non-radiative recombination losses of carriers at the interface.

In one embodiment, the interface passivation material includes any one of the following structures C1 to C27:

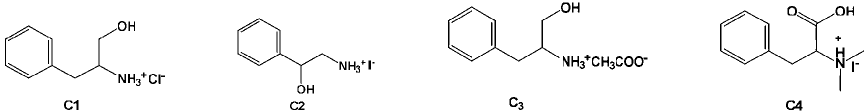

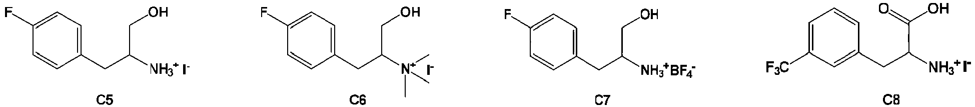

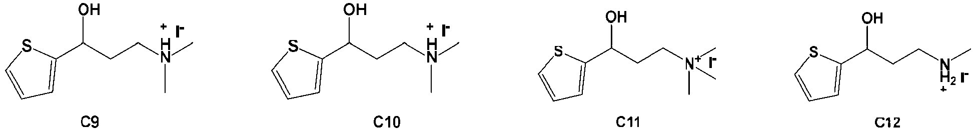

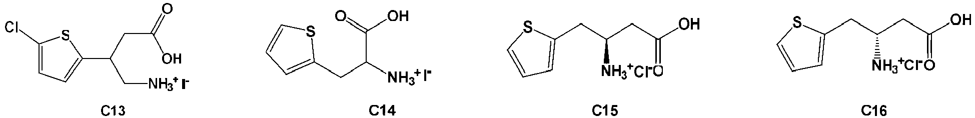

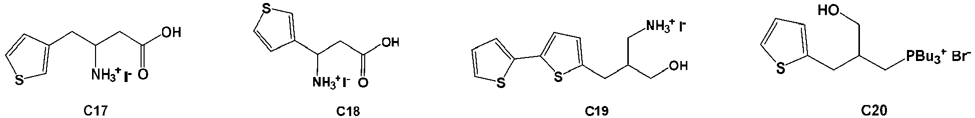

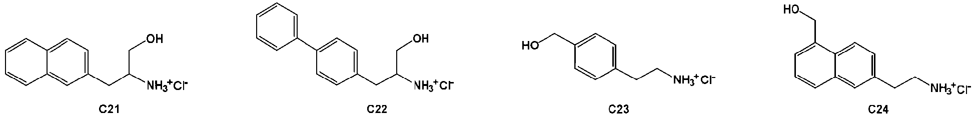

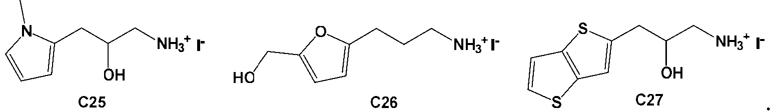

The above interface passivation material can passivate defects at the interface of the perovskite layer, induce ordered stacking at the interface of the adjacent carrier transport layer, and block the migration of anions in the perovskite, thereby improving carrier transport performance and improving the photoelectric conversion efficiency and stability of the solar cell device.

In one embodiment, the solar cell further includes a substrate layer, a first electrode, a first transport layer, a light absorption layer, a second transport layer, and a second electrode that are sequentially stacked; and the interface passivation material is distributed in one or more layers of the first transport layer, the light absorption layer, or the second transport layer. Through the above configuration, the preparation process of the solar cell can be simplified, improving production efficiency.

In one embodiment, based on a total mass of a doped base layer, a doping ratio of the interface passivation material is 0.005% to 5%, and the doped base layer is any one of the first transport layer, the light absorption layer, or the second transport layer. This achieves the passivation effect without affecting carrier transport.

In one embodiment, the first transport layer is an electron transport layer, and the second transport layer is a hole transport layer, or the first transport layer is a hole transport layer, and the second transport layer is an electron transport layer. That is, the solar cell can have a conventional structure or an inverted structure, expanding the types of solar cells applicable to the interface passivation material.

In one embodiment, the solar cell includes a substrate layer, a first electrode, a first transport layer, a light absorption layer, a second transport layer, and a second electrode that are sequentially stacked, and the solar cell further includes a passivation layer, where the interface passivation material is distributed in the passivation layer, the passivation layer being located between the first transport layer and the light absorption layer, and/or the passivation layer being located between the second transport layer and the light absorption layer. The passivation layer can passivate defects at the perovskite interface, improving carrier transport performance.

In one embodiment, a thickness of the passivation layer is 0.1 nm to 10 nm. Within this thickness range, the passivation effect can be achieved without affecting carrier transport.

In one embodiment, the first electrode, the first transport layer, the light absorption layer, the second transport layer, and the second electrode are sequentially arranged from bottom to top from a light incident surface of the substrate layer, the first transport layer is a hole transport layer, the second transport layer is an electron transport layer, the light absorption layer includes a perovskite material, and the passivation layer is located between the electron transport layer and the perovskite layer. The carrier transport performance of this solar cell is improved, and the energy conversion efficiency and stability are improved.

In one embodiment, a material of the first electrode includes any one of fluorine-doped tin oxide, indium tin oxide, aluminum-doped zinc oxide, boron-doped zinc oxide, or indium-doped zinc oxide; and/or the light absorption layer includes a perovskite material, the perovskite material including any one of ABX₃ or A₂CDX₆, where A is any one of an inorganic cation, an organic cation, or an organic-inorganic hybrid cation, optionally at least one of a methylammonium ion, an n-butylammonium ion, or a cesium ion; B is any one of an inorganic cation, an organic cation, or an organic-inorganic hybrid cation, optionally at least one of a lead ion or a tin ion; C is any one of an inorganic cation, an organic cation, or an organic-inorganic hybrid cation, optionally a silver ion; D is any one of an inorganic cation, an organic cation, or an organic-inorganic hybrid cation, optionally at least one of a bismuth ion, an antimony ion, or an indium ion; X is any one of an inorganic anion, an organic anion, or an organic-inorganic hybrid anion, optionally at least one of a bromide ion or an iodide ion; and/or a material of the electron transport layer includes at least one of [6,6]-phenyl-C₆₁-butyric acid methyl ester (PC₆₁BM), [6,6]-phenyl-C₇₁-butyric acid methyl ester (PC₇₁BM), fullerene C₆₀ (C₆₀), fullerene C₇₀ (C₇₀), tin dioxide (SnO₂), zinc oxide (ZnO), a perylene diimide (PDI)-based material, a naphthalene diimide (NDI)-based material, a derivative thereof, or a material obtained by doping or passivation thereof; and/or a material of the hole transport layer includes one or more of a metal oxide material, a polymer material, an organic small molecule self-assembled molecular material, a derivative thereof, or a material obtained by doping or passivation thereof, optionally one or more of nickel oxide (NiOₓ₂, 1≤x2≤1.5), molybdenum oxide (MoOₓ₃, 2.5≤x3≤3), tungsten oxide (WOₓ₃), poly[bis(4-phenyl)(2,4,6-trimethylphenyl)amine] (PTAA), poly(3,4-ethylenedioxythiophene)-poly(styrenesulfonate) (PEDOT:PSS), or carbazole or a triphenylamine-based material containing phosphate or a carboxylic acid group; and/or an electrode material of the second electrode includes one or more of an organic conductive material, an inorganic conductive material, or an organic-inorganic hybrid conductive material, optionally one or more of silver, copper, carbon, gold, aluminum, indium tin oxide, aluminum-doped zinc oxide, boron-doped zinc oxide, or indium-doped zinc oxide. The energy conversion efficiency and stability of this solar cell are improved.

In one embodiment, a thickness of the first electrode is 10 nm to 1000 nm; and/or a bandgap of the perovskite layer is 1.20 eV to 2.30 eV, and a thickness of the perovskite layer is 200 nm to 1000 nm; and/or a thickness of the electron transport layer is 5 nm to 100 nm; and/or a thickness of the hole transport layer is 0.5 nm to 50 nm; and/or a thickness of the second electrode is 10 nm to 1000 nm. The energy conversion efficiency and stability of this solar cell are improved.

In one embodiment, the solar cell further includes a blocking layer, the blocking layer being located between the electron transport layer and the first electrode layer or the second electrode layer; and a material of the blocking layer includes one or more of 2,9-dimethyl-4,7-diphenyl-1,10-phenanthroline, tin dioxide, zinc oxide, or cerium oxide, where the chemical formula of cerium oxide is CeOₓ₁, and 1.5≤x1≤2, and a thickness of the blocking layer is 0.5 nm to 200 nm. The blocking layer is configured to prevent reactions between the first electrode or the second electrode and the perovskite, and also has the function of energy-level regulation, reducing energy and charge losses caused by interface charge recombination, thereby improving the energy conversion efficiency of the device.

To address the above technical problem, another technical solution adopted by the present application is to provide an interface passivation material, the interface passivation material including a first compound represented by chemical formula (1) and/or a second compound represented by chemical formula (2): 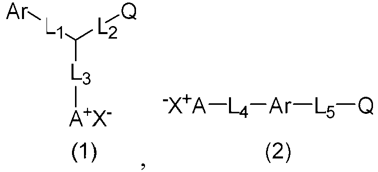 where, Ar is an aromatic group; Q is a functional group containing active hydrogen; A⁺ is selected from an ammonium group or a phosphonium group; X⁻ is selected from any one of a halogen ion, a pseudohalogen ion, an oxyanion ion, a fluoroanion ion, or a sulfonyl imide anion; L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, where the heteroatom includes one or more of a nitrogen atom, an oxygen atom, or a sulfur atom, and an alkylene chain with 0 carbon atoms indicates that the two groups connected to L1 to L5 are directly connected.

The above interface passivation material can passivate defects at the interface of the perovskite layer, induce ordered stacking at the interface of the adjacent carrier transport layer, and block the migration of anions in perovskite, thereby improving carrier transport performance and improving the photoelectric conversion efficiency and stability of the solar cell device.

To address the above technical problem, another technical solution adopted by the present application is to provide a photovoltaic power generation system, including the solar cell according to any one of the above. The photovoltaic power generation system has at least the same advantages as the solar cell.

To address the above technical problem, another technical solution adopted by the present application is to provide an electric device, including the solar cell according to any one of the above. The electric device has at least the same advantages as the solar cell.

The foregoing descriptions are merely an overview of the technical solution of the present application. For a better understanding of the technical means in the present application such that they can be implemented according to the content of the specification, and to make the above and other objectives, features and advantages of the present application more obvious and easier to understand, the following describes specific embodiments of the present application.

### DESCRIPTION OF DRAWINGS

To describe the technical solutions in the embodiments of the present application more clearly, the following briefly describes the accompanying drawings required for the embodiments. Apparently, the accompanying drawings in the following description show merely some embodiments of the present application, and persons of ordinary skill in the art may still derive other drawings from these accompanying drawings without creative efforts.
FIG. 1 is a schematic structural diagram of a solar cell according to one or more embodiments; and
FIG. 2 is a schematic structural diagram of a solar cell according to one or more embodiments.

In the drawings:
100. cell; 11. first electrode; 13. second electrode; 21. first transport layer; 23. second transport layer; 30. light absorption layer; and 40. passivation layer.

### DESCRIPTION OF EMBODIMENTS

To make the objectives, technical solutions, and effects of the present application clearer and more explicit, the following describes the embodiments of the present application in detail with reference to the accompanying drawings. The following embodiments are merely intended for a clearer description of the technical solutions of the present application and therefore are merely used as examples which do not constitute any limitation on the protection scope of the present application.

Unless otherwise defined, all technical and scientific terms used herein shall have the same meanings as commonly understood by persons skilled in the art to which the present application relates. The terms used herein are intended to merely describe the specific embodiments rather than to limit the present application. The terms "include", "comprise", and "have" and any other variations thereof in the specification, claims and brief description of drawings of the present application are intended to cover non-exclusive inclusions.

In the descriptions of the embodiments of the present application, the technical terms "first", "second", and the like are merely intended to distinguish between different objects, and shall not be understood as any indication or implication of relative importance or any implicit indication of the number, specific sequence, or primary-secondary relationship of the technical features indicated. In the descriptions of the embodiments of the present application, the term "multiple" means more than two (inclusive). Similarly, "multiple groups" means more than two (inclusive) groups, and "multiple pieces" means more than two (inclusive) pieces, unless otherwise specifically defined.

In this specification, reference to "embodiment" means that specific features, structures, or characteristics described with reference to the embodiment may be included in at least one embodiment of the present application. The term "embodiment" appearing in various places in the specification does not necessarily refer to the same embodiment or an independent or alternative embodiment that is exclusive of other embodiments. It is explicitly or implicitly understood by persons skilled in the art the embodiments described herein may be combined with other embodiments.

In the description of some embodiments of the present application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

Quantities, ratios, and other values are presented in the format of range in this specification. It should be understood that such format of range is used for convenience and simplicity and should be flexibly understood as including not only values explicitly designated as falling within the range but also all individual values or sub-ranges covered by the range as if each value and sub-range are explicitly designated.

Unless otherwise specified, all the steps in the present application can be performed in the order described or in random order, and preferably, may be performed in the order described. For example, a method including steps (a) and (b) indicates that the method may include steps (a) and (b) performed sequentially or may include steps (b) and (a) performed sequentially. For example, the foregoing method may further include step (c), indicating that step (c) may be added to the method in any ordinal position, for example, the method may include steps (a), (b), and (c), steps (a), (c), and (b), steps (c), (a), and (b), or the like.

Solar cells, as an important technology in the field of new energy technologies, have expanded from military and aerospace applications to various fields such as industry, commerce, agriculture, communications, household appliances, and public facilities. Perovskite solar cells (Perovskite Solar Cells, PSCs) are among the most promising and potential solar cells, characterized by high efficiency, environmental friendliness, and low cost.

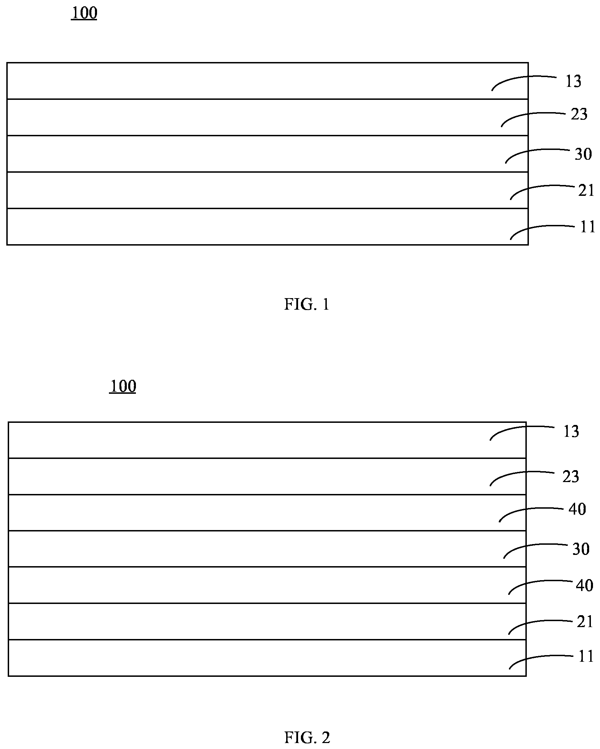

Referring to FIG. 1, FIG. 1 is a schematic structural diagram of a solar cell according to one or more embodiments. A solar cell 100 includes a substrate layer (not shown in the figure), a first electrode 11, a first transport layer 21, a light absorption layer 30, a second transport layer 23, and a second electrode 13 that are sequentially stacked; and the first transport layer 21 and the second transport layer 23 are respectively one of an electron transport layer or a hole transport layer.

In some embodiments, the solar cell has an inverted structure, with the first transport layer being a hole transport layer and the second transport layer being an electron transport layer.

In some embodiments, the solar cell has a conventional structure, with the first transport layer being an electron transport layer and the second transport layer being a hole transport layer.

The substrate layer is a transparent substrate layer. A material of the substrate layer includes glass and/or polymer. Optionally, the polymer includes one or more of polyvinyl alcohol (PVA), polyester (PET), polyimide (PI), polyethylene naphthalate (PEN), and polydimethylsiloxane (PDMS). In some embodiments, the substrate layer may also not be provided.

The first electrode is a transparent conductive substrate with high conductivity and high visible light transmittance, and has the function of collecting charges. In some embodiments, a material of the first electrode is selected from a transparent conductive oxide material, including any one of fluorine-doped tin oxide (FTO), indium tin oxide (ITO), aluminum-doped zinc oxide (AZO), boron-doped zinc oxide (BZO), or indium-doped zinc oxide (IZO). A thickness of the first electrode is 10 nm to 1000 nm.

The light absorption layer is configured to absorb light and directly convert light energy into electrical energy through the photoelectric effect or photochemical effect.

The light absorption layer includes a light-absorbing material and has a photoelectric conversion function. The light-absorbing material absorbs photons from sunlight to generate excitation, and electrons in an excitation valence band generate photo-generated electron-hole pairs. The binding energy of electron-hole pairs is small, and dissociation is prone to occur under the action of the built-in electric field, thereby separating into free electrons and free holes, that is, carriers.

In some embodiments, a material of the light absorption layer includes, but is not limited to, perovskite. The chemical composition of the perovskite includes any one of ABX₃ or A₂CDX₆, where A is any one of an inorganic cation, an organic cation, or an organic-inorganic hybrid cation, and may be at least one of a methylammonium ion (CH₃NH₃⁺, MA⁺), an n-butylammonium ion (HC(NH₂)₂⁺, FA⁺), or a cesium ion (Cs⁺); B is any one of an inorganic cation, an organic cation, or an organic-inorganic hybrid cation, and may be at least one of a lead ion (Pb²⁺) or a tin ion (Sn²⁺); C is any one of an inorganic cation, an organic cation, or an organic-inorganic hybrid cation, and may be a silver ion (Ag⁺); D is any one of an inorganic cation, an organic cation, or an organic-inorganic hybrid cation, and may be at least one of a bismuth ion (Bi³⁺), an antimony ion (Sb³⁺), or an indium ion (In³⁺); and X is any one of an inorganic anion, an organic anion, or an organic-inorganic hybrid anion, and may be at least one of a bromide ion (Br⁻) or an iodide ion (I⁻). The bandgap of the perovskite layer is 1.20 eV to 2.30 eV, and a thickness of the perovskite layer is 200 nm to 1000 nm.

The function of the electron transport layer is to efficiently transport free electrons generated by the perovskite layer, effectively block the passage of free holes, and form an ohmic contact at the interface with the perovskite active layer.

In some embodiments, a material of the electron transport layer includes at least one of the following materials, a derivative thereof, or a material obtained by doping or passivation thereof. The material of the electron transport layer includes, but is not limited to, an imide compound, a quinone compound, fullerene and a derivative thereof, metal oxide, semiconductor material oxide, titanates, or fluorides. The imide compound includes at least one of perylene diimide and a derivative thereof, naphthalene diimide and a derivative thereof, phthalimide, succinimide, N-bromosuccinimide, glutarimide, or maleimide. The quinone compound includes at least one of benzoquinone, naphthoquinone, phenanthrenequinone, or anthraquinone. Fullerenes and a derivative thereof include at least one of [6,6]-phenyl-C₆₁-butyric acid methyl ester (PC₆₁BM), [6,6]-phenyl-C₇₁-butyric acid methyl ester (PC₇₁BM), fullerene C₆₀ (C₆₀), or fullerene C₇₀ (C₇₀). The metal element in the metal oxide includes at least one of magnesium (Mg), cadmium (Cd), zinc (Zn), indium (In), lead (Pb), tungsten (W), antimony (Sb), bismuth (Bi), mercury (Hg), titanium (Ti), silver (Ag), manganese (Mn), iron (Fe), vanadium (V), tin (Sn), zirconium (Zr), strontium (Sr), gallium (Ga), or chromium (Cr). The semiconductor material oxide includes silicon oxide. The titanate includes at least one of strontium titanate or calcium titanate. Fluoride includes at least one of lithium fluoride or calcium fluoride. A thickness of the electron transport layer is 5 nm to 100 nm.

The hole transport layer is configured to transport free holes to the corresponding electrode and prevent free holes from diffusing in an opposite direction.

In some embodiments, a material of the hole transport layer includes one or more of a metal oxide material, a polymer material, an organic small molecule self-assembled molecular material, a derivative thereof, or a material obtained by doping or passivation thereof, such as, but not limited to, a metal oxide material, for example, nickel oxide (NiOₓ₂, 1≤x2≤1.5), molybdenum oxide (MoOₓ₃, 2.5≤x3≤3), tungsten oxide (WOₓ₄, 2.5≤x4≤3); a polymer material, for example, poly[bis(4-phenyl)(2,4,6-trimethylphenyl)amine] (PTAA), poly(3,4-ethylenedioxythiophene)-poly(styrenesulfonate) (PEDOT:PSS); an organic small molecule self-assembled molecular material, for example, carbazole or a triphenylamine-based material containing phosphate or a carboxylic acid group. A thickness of the hole transport layer is 0.5 nm to 50 nm.

The second electrode has the function of collecting free charges. In some embodiments, an electrode material of the second electrode includes one or more of an organic conductive material, an inorganic conductive material, or an organic-inorganic hybrid conductive material, including silver (Ag), copper (Cu), carbon (C), gold (Au), aluminum (Al), indium tin oxide (ITO), aluminum-doped zinc oxide (AZO), boron-doped zinc oxide (BZO), indium-doped zinc oxide (IZO), and the like. A thickness of the second electrode is 10 nm to 1000 nm.

In one embodiment, the solar cell provided by the present application further includes a blocking layer, the blocking layer being located between the electron transport layer and the first electrode layer, or the blocking layer being located between the electron transport layer and the second electrode layer. The blocking layer is configured to prevent reactions between the first electrode or the second electrode and the perovskite, mitigating the device efficiency reduction caused by Schottky contact between the electron transport layer and the electrode, and also has the function of energy-level regulation. The valence band energy level of the blocking layer is relatively low, far below the valence band energy level of the perovskite layer, effectively preventing hole injection. Thus, this configuration can reduce energy and charge losses caused by interface charge recombination, thereby improving the energy conversion efficiency of the device.

Further, a material of the blocking layer includes one or more of 2,9-dimethyl-4,7-diphenyl-1,10-phenanthroline (BCP), tin dioxide (SnO₂), zinc oxide (ZnO), or cerium oxide (CeOₓ₁, 1.5≤x1≤2), and a thickness of the blocking layer is 0.5 nm to 20 nm.

Currently, the highest efficiency achieved by single-junction perovskite solar cells is still far below the theoretical Shockley-Queisser limit efficiency of 30.5%, indicating substantial room for improvement. Meanwhile, the stability of perovskite solar cells under various environmental conditions does not meet commercialization standards. The photoelectric conversion efficiency and stability of perovskite solar cells are closely related to the nonradiative recombination (Nonradiative Recombination, NRR) process of carriers inside the device and at the interface. Reducing NRR losses can effectively improve photoelectric conversion efficiency and stability. In-depth studies show that NRR in perovskite solar cells is mainly due to various types of defects at the perovskite interface, primarily including shallow-level defects and deep-level defects. Deep-level defects can trap electrons or holes, causing the same to be annihilated by carriers of opposite charge, leading to the loss of charge carriers in the perovskite material; and shallow-level defects can migrate to the interface under the action of an electric field, affecting the photovoltaic performance of perovskite solar cells.

Studies have found that surface passivation by introducing a suitable material at the perovskite interface can repair defects at the interface, thereby effectively improving the photoelectric conversion efficiency and stability of perovskite solar cells.

Based on this, the present application provides a solar cell, an interface passivation material, a photovoltaic power generation system, and an electric device, so as to improve defects at the perovskite interface, achieve interface passivation, reduce nonradiative recombination losses caused by carrier recombination at the interface, improve carrier transport performance, and improve the photoelectric conversion efficiency of the solar cell.

According to some embodiments of the present application, the solar cell includes an interface passivation material, the interface passivation material including a first compound represented by chemical formula (1) and/or a second compound represented by chemical formula (2): 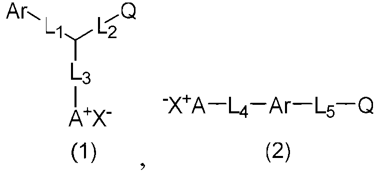 where, Ar is an aromatic group; Q is a functional group containing active hydrogen; A⁺ is selected from an ammonium group or a phosphonium group; X⁻ is selected from any one of a halogen ion, a pseudohalogen ion, an oxyanion ion, a fluoroanion ion, or a sulfonyl imide anion; L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, where the heteroatom includes one or more of a nitrogen atom, an oxygen atom, or a sulfur atom, and an alkylene chain with 0 carbon atoms indicates that the two groups connected to L1 to L5 are directly connected.

The heteroatom-containing chain with 0 to 10 carbon atoms means that based on an alkylene chain with 0 to 10 carbon atoms, some carbon atoms on the alkylene chain are replaced by heteroatoms, making the alkylene chain a heteroatom chain, with the total number of heteroatoms and carbon atoms being 0 to 10. When the number is 0, it indicates that the two groups connected to L1 to L5 are directly connected; when the number is 1, it indicates that L1 to L5 is a single heteroatom; and when the number is 2 to 10, it indicates that L1 to L5 includes both heteroatoms and carbon atoms.

The above interface passivation material can: firstly, passivate defects at the interface of the perovskite layer, reducing nonradiative recombination losses of carriers at the interface, secondly, induce ordered stacking at the interface of the adjacent carrier transport layer, improving carrier transport performance, and thirdly, block the migration of anions in the perovskite, mitigating defects caused by ion migration. Therefore, the interface passivation material can improve the photoelectric conversion efficiency and stability of the solar cell device.

In one embodiment, Q in the above interface passivation material is selected from any one of a hydroxyl group (-OH), a carboxyl group (-COOH), a sulfhydryl group (-SH), an amino (-NR'H), or an amide group (-NHCOR); R' is selected from any one of a hydrogen atom, an alkyl chain with 1 to 10 carbon atoms, or a halogen-substituted alkyl chain with 1 to 10 carbon atoms; and R is selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, where the heteroatom includes one or more of a nitrogen atom, an oxygen atom, or a sulfur atom.

Q is a functional group containing active hydrogen, where active hydrogen refers to a hydrogen atom that is easily detached from the atom, forms a free radical reaction, or participates in other chemical reactions. The hydrogen atom in the hydroxyl group (-OH) can easily detach from the hydroxyl group through proton transfer, forming a free hydrogen ion (H⁺). Additionally, the oxygen atom in the hydroxyl group has high electronegativity and strong electrophilicity, promoting the detachment of the hydrogen ion. The hydroxyl hydrogen in the carboxyl group (-COOH) is more easily dissociated than the hydroxyl hydrogen in an alcohol, showing weak acidity. The sulfur atom in the sulfhydryl group (-SH) also has relatively high electronegativity, promoting the detachment of the hydrogen ion. The nitrogen atom in the amino (-NR'H) has relatively high electronegativity, promoting the detachment of the hydrogen ion. In the amide group (-NHCOR), π electrons in the carbonyl group form p-π conjugation with the p orbital occupied by the lone pair electrons on the nitrogen atom, reducing the electron cloud density on the nitrogen atom and enhancing the polarity of the N-H bond, making the hydrogen atom active.

The functional group (Q) containing active hydrogen can provide active hydrogen to interact with strongly electronegative groups in the adjacent carrier transport layer, such as oxygen atoms (-O-) or fluorine atoms (-F-) containing lone pair electrons, forming hydrogen bonds or other strong interactions, and can also induce ordered stacking at the interface of the adjacent carrier transport layer, thereby improving carrier transport performance and improving the performance of the solar cell device.

In one embodiment, in the above interface passivation material, in the first compound, Ar includes any one of the following structures Ar1 to Ar15: 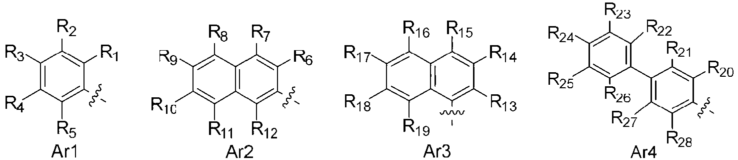 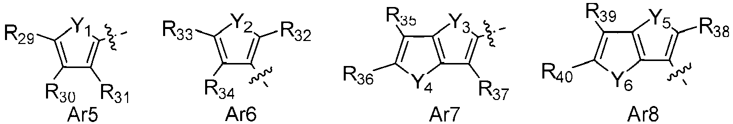 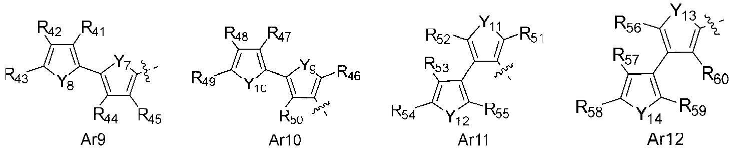 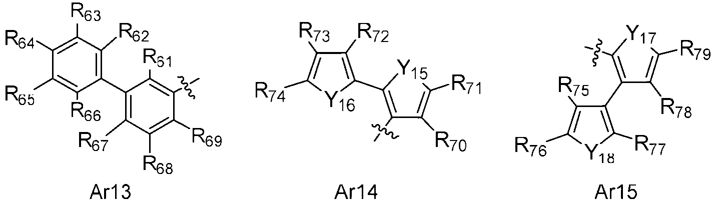
where, Y1 to Y18 are selected from any one of an oxygen atom (-O-), a sulfur atom (-S-), or an R'-substituted nitrogen atom (-NR'-); R' is selected from any one of a hydrogen atom, an alkyl chain with 1 to 10 carbon atoms, or a halogen-substituted alkyl chain with 1 to 10 carbon atoms; and R1 to R79 are selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, where the heteroatom includes one or more of a nitrogen atom, an oxygen atom, or a sulfur atom;
where, 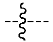 represents a single-bond attachment site, and when a structure of the interface passivation material is 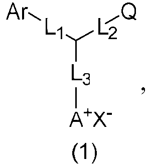 the structures Ar1 to Ar15 are connected to L1 through 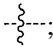 and/or
in the second compound, Ar includes any one of the following structures Ar16 to Ar30,
where, Ar16 differs from Ar1 in that any one of R1 to R5 is replaced by 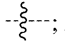 Ar17 differs from Ar2 in that any one of R6 to R12 is replaced by 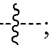 Ar18 differs from Ar3 in that any one of R13 to R19 is replaced by 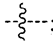 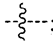 Ar19 differs from Ar4 in that any one of R20 to R28 is replaced by 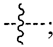 Ar20 differs from Ar5 in that any one of R29 to R31 is replaced by 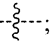 Ar21 differs from Ar6 in that any one of R32 to R34 is replaced by 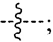 Ar22 differs from Ar7 in that any one of R35 to R37 is replaced by 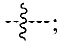 Ar23 differs from Ar8 in that any one of R38 to R40 is replaced by 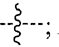 Ar24 differs from Ar9 in that any one of R41 to R45 is replaced by 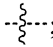 Ar25 differs from Ar10 in that any one of R46 to R50 is replaced by - 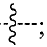 Ar26 differs from Ar11 in that any one of R51 to R55 is replaced by 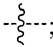 Ar27 differs from Ar12 in that any one of R56 to R60 is replaced by 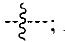 Ar28 differs from Ar13 in that any one of R61 to R69 is replaced by 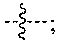 Ar29 differs from Ar14 in that any one of R70 to R74 is replaced by 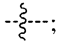 and Ar30 differs from Ar15 in that any one of R75 to R79 is replaced by

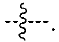

When the structure of the interface passivation material is 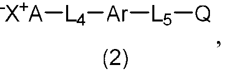 the structures Ar16 to Ar30 are connected to L4 and L5, respectively, through

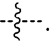

Y1 to Y18 may be the same or different groups; and R1 to R79 may be the same or different groups.

The aromatic group (Ar) can accumulate at the interface of the perovskite layer, blocking the migration of anions in the perovskite layer, thereby improving the stability of the perovskite solar cell. In addition, Ar can also induce the stacking of organic fused-ring molecules in the adjacent carrier transport layer through π-π interactions, making its arrangement more ordered, thereby improving carrier transport performance and improving the performance of the solar cell device.

In one embodiment, in the above interface passivation material, A⁺ is selected from an ammonium group or a phosphonium group, the ammonium group including -NR'³⁺, and the phosphonium group including -PR'³⁺, wherein R' is selected from any one of a hydrogen atom, an alkyl chain with 1 to 10 carbon atoms, or a halogen-substituted alkyl chain with 1 to 10 carbon atoms.

The ammonium group and phosphonium group are cationic functional groups, so A⁺ can passivate A-site defects at the interface of the perovskite layer of ABX₃ or A₂CDX₆, stabilize the lattice, reduce nonradiative recombination losses of carriers at the interface, and improve the performance of the solar cell device.

In one embodiment, in the above interface passivation material, X⁻ is selected from any one of a halogen ion, a pseudohalogen ion, an oxyanion ion, a fluoroanion ion, or a sulfonyl imide anion, where the halogen ion includes any one of a fluoride ion (F⁻), a chloride ion (Cl⁻), a bromide ion (Br⁻), or an iodide ion (I⁻); the pseudohalogen ion includes any one of a cyanide ion (CN⁻), a cyanate ion (OCN⁻), or a thiocyanate ion (SCN⁻); the fluoroanion ion includes any one of a tetrafluoroborate ion (BF₄⁻) or a hexafluorophosphate ion (PF₆⁻); and the sulfonyl imide anion includes a bis(trifluoromethylsulfonyl)imide anion [(CF₃SO₂)₂N⁻]. The oxyanion ion includes any one of NO₃⁻, ClO₃⁻, R"SO₃⁻, R"COO⁻, or R"PO₂(OH)⁻, where R" is selected from any one of a hydrogen atom, an alkyl chain with 1 to 10 carbon atoms, a halogen-substituted alkyl chain with 1 to 10 carbon atoms, Ar1 to Ar15, or an alkyl chain with 1 to 10 carbon atoms substituted with Ar1 to Ar15. Specifically, the oxyanion ion includes any one of a p-toluenesulfonate ion, a trifluoromethanesulfonate ion, a fluorosulfonate ion, or a methyl phosphate ion.

The X⁻ anion can effectively passivate iodine vacancy defects in the perovskite layer or coordinate with under-coordinated lead ions, reducing non-radiative recombination losses of carriers at the interface. For example, Cl⁻ can improve the crystallization and morphology of the perovskite layer and improve photoelectric performance (carrier lifetime, diffusion length, and the like); I⁻ can fill halide vacancies at the grain boundaries of the perovskite layer, thereby passivating defects and reducing non-radiative recombination of carriers; SCN⁻ can passivate cation defects and grain boundaries, forming a more stable and robust crystal structure with Pb²⁺ compared to a halide group, while also enhancing water resistance, light absorption, and reducing leakage current.

In one embodiment, the interface passivation material includes any one of the following structures C1 to C27:

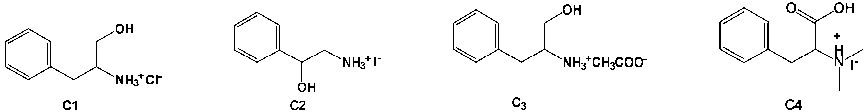

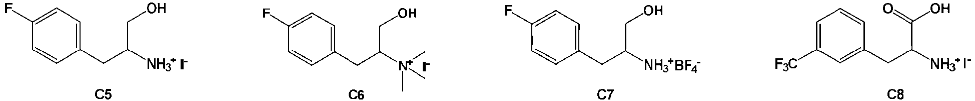

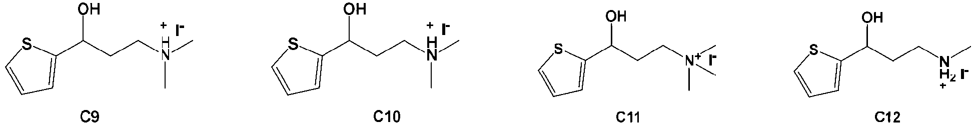

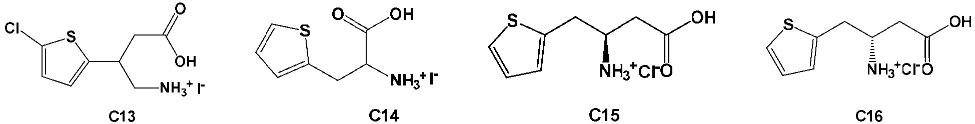

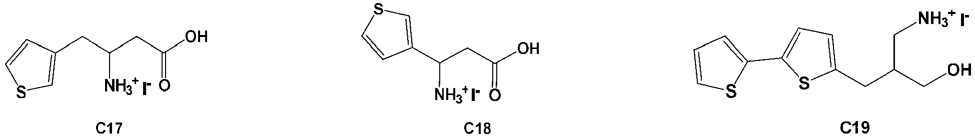

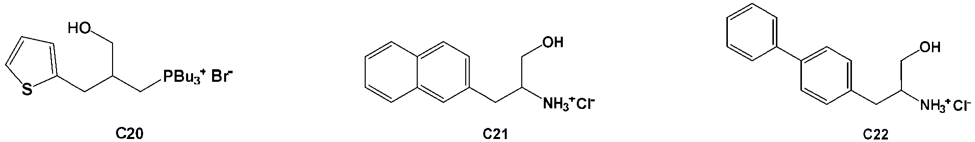

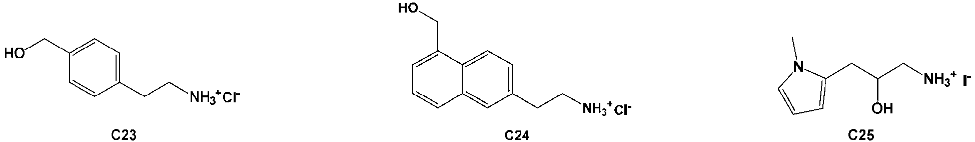

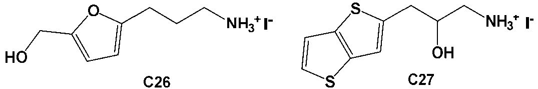

In one embodiment, the interface passivation material may be distributed in one or more layers of the first transport layer, the light absorption layer, or the second transport layer.

The distribution of the interface passivation material in one or more layers of the first transport layer, the light absorption layer, or the second transport layer refers to the preparation of a layer film after the interface passivation material is uniformly blended with the substances in the above layers. This can simplify the preparation process of the solar cell, improving production efficiency.

Based on a total mass of the doped base layer, a doping ratio of the interface passivation material is 0.005% to 5%, for example, 0.005%, 0.01%, 0.05%, 0.1%, 0.3%, 0.5%, 0.8%, 1%, 1.5%, 2%, 3%, 4%, or 5%. The doped base layer is any one of the first transport layer, the light absorption layer, or the second transport layer. That is, when the passivation material is doped into a specific layer, a doping amount is calculated based on the total mass of that layer. For example, when the passivation material is doped into the first transport layer, its doping weight ratio is 0.5% to 1% of the total mass of the first transport layer.

In one embodiment, the interface passivation material can also form a separate passivation layer, specifically, the solar cell further includes a passivation layer, where the interface passivation material is distributed in the passivation layer, the passivation layer being located between the first transport layer and the light absorption layer, and/or the passivation layer being located between the second transport layer and the light absorption layer.

The passivation layer can be prepared at the interface between the hole transport layer and the light absorption layer or at the interface between the electron transport layer and the light absorption layer. The passivation layer can passivate defects at the perovskite interface, thereby reducing non-radiative recombination losses of carriers at the interface and improving carrier transport performance.

The passivation layer can be prepared using methods such as blade coating, spin coating, spray coating, slot-die coating, or chemical vapor deposition.

A thickness of the passivation layer is 0.1 nm to 10 nm. Increasing the thickness of the passivation layer can enhance the passivation effect. However, due to the relatively low conductivity of the interface passivation material, an excessively thick passivation layer can limit current transport. Therefore, the thickness of the passivation layer in the range of 0.1 nm to 10 nm can achieve the passivation effect without affecting current transport, reducing non-radiative recombination losses of carriers.

Referring to FIG. 2, FIG. 2 is a schematic structural diagram of a solar cell according to one or more embodiments. In one embodiment, taking an inverted perovskite solar cell as an example, a first electrode 11, a first transport layer 21, a light absorption layer 30, a second transport layer 23, and a second electrode 13 of the solar cell 100 are sequentially arranged from bottom to top from the substrate layer, where the first transport layer 21 is a hole transport layer, the second transport layer 23 is an electron transport layer, the light absorption layer 30 is a perovskite layer, and the passivation layer 40 is located between the electron transport layer and the perovskite layer, and/or the passivation layer 40 is located between the perovskite layer and the hole transport layer.

The preparation of the inverted-structured perovskite solar cell includes the following steps:
S1: Etch and clean the first electrode substrate, and dry it for later use.
S2: Prepare the hole transport layer on the clean first electrode substrate for later use.
S3: Prepare a perovskite light absorption layer on the hole transport layer for later use.
S4: Prepare the electron transport layer and the blocking layer on the perovskite light absorption layer for later use.
S5: Prepare the second electrode layer on the blocking layer, and perform edge cleaning and testing.

In one embodiment, the interface passivation material is doped in one or more layers of the hole transport layer, the perovskite layer, or the electron transport layer. The doping method involves mixing the interface passivation material with the precursor solution of each layer.

In one embodiment, the interface passivation material forms a separate layer, prepared at the interface between the hole transport layer and the perovskite layer, and/or at the interface between the perovskite layer and the electron transport layer. The preparation method may include, but is not limited to, blade coating, spin coating, spray coating, slot-die coating, or chemical vapor deposition.

According to some embodiments of the present application, the present application also provides an interface passivation material, the interface passivation material including a first compound represented by chemical formula (1) and/or a second compound represented by chemical formula (2): 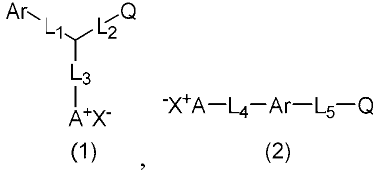 where, Ar is an aromatic group; Q is a functional group containing active hydrogen; A⁺ is selected from an ammonium group or a phosphonium group; X⁻ is selected from any one of a halogen ion, a pseudohalogen ion, an oxyanion ion, a fluoroanion ion, or a sulfonyl imide anion; L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, where the heteroatom includes one or more of a nitrogen atom, an oxygen atom, or a sulfur atom, and an alkylene chain with 0 carbon atoms indicates that the two groups connected to L1 to L5 are directly connected.

The above interface passivation material can passivate defects at the interface of the perovskite layer, induce ordered stacking at the interface of the adjacent carrier transport layer, and block the migration of anions in the perovskite, thereby improving carrier transport performance and improving the photoelectric conversion efficiency and stability of the solar cell device.

According to some embodiments of the present application, the present application also provides a photovoltaic power generation system, including the solar cell according to any one of the above.

The photovoltaic power generation system refers to a power generation system that directly converts solar radiation energy into electrical energy using the photovoltaic effect, and is divided into a stand-alone photovoltaic power generation system (Stand-alone PV System) and a grid-connected photovoltaic power generation system (Grid-connected PV System). The stand-alone photovoltaic power generation system consists of a solar photovoltaic array composed of photovoltaic modules, a battery pack, a charge controller, a power electronic converter (inverter), and a load. The grid-connected photovoltaic power generation system consists of a photovoltaic array, a high-frequency DC/DC boost circuit, a power electronic converter (inverter), and a system monitoring component.

The photovoltaic power generation system includes several electrically connected photovoltaic modules, where several refers to an integer number of two or more.

According to some embodiments of the present application, the present application also provides an electric device, including the solar cell provided by the above solutions, and the solar cell is configured to provide electrical energy to the electric device.

The electric device includes common devices incorporating the solar cell of the present application, such as those in the field of communications, the field of transportation, the field of industry, agriculture, and the field of lighting. The electric device may include, for example, a satellite, a communication device, a traffic signal light, a lighthouse, a wireless telephone booth, a monitoring device in the oil drilling field, a power system, a camping light, an electric vehicle, and an electronic device charger.

The power supply method for the electric device can be solely from the solar cell or a combination of the solar cell and a storage battery, that is, the electric device is equipped with both a solar cell and a storage battery. The storage battery is not limited to a primary battery or a secondary battery, such as, but not limited to, a lithium-ion secondary battery, and a sodium-ion secondary battery.

The following further describes the beneficial effects of the present application with reference to examples.

To describe the technical problems solved by the embodiments of the present application, technical solutions, and beneficial effects more clearly, further description is made in detail with reference to the embodiments and accompanying drawings. Apparently, the described embodiments are only some rather than all of these embodiments of the present application. The following description of at least one exemplary example is merely illustrative and definitely is not construed as any limitation on the present application or on use of the present application. All other embodiments obtained by persons of ordinary skill in the art on the basis of the embodiments of the present application without creative efforts shall fall within the protection scope of the present application.

### I. Preparation of interface passivation materials

### (1) Synthesis of C1:

2-amino-3-phenylpropanol (10 mmol) was dissolved in ethanol (50 mL), the solution was cooled to 0°C, an aqueous solution (36% by mass, 2.5 mL) of hydrochloric acid was added dropwise to the above solution, and the solution was stirred for 3 h. After the solvent was removed, recrystallization was performed in diethyl ether to obtain a compound C1 with a yield of approximately 67%. An H nuclear magnetic resonance spectrum (¹H NMR) was measured under an applied magnetic field strength of 400 MHz with deuterated dimethyl sulfoxide (DMSO-*d*₆) as the solvent. The test results were: chemical shift δ = 8.34 (s, 3H); δ = 7.22-7.18 (m, 5H); δ = 4.26-4.18 (m, 3H); δ = 3.98-3.94 (m, 1H); and δ = 3.33-3.26 (m, 2H), where s represented a singlet, and m represented a multiplet.

### (2) Synthesis of C2:

2-amino-1-phenylethanol (10 mmol) was dissolved in ethanol (50 mL), the solution was cooled to 0°C, an aqueous solution (55%-57% by mass, 1.5 mL) of hydroiodic acid was added dropwise to the above solution, and the solution was stirred for 5 h. After the solvent was removed, recrystallization was performed in diethyl ether to obtain a compound C2 with a yield of approximately 54%. An H nuclear magnetic resonance spectrum (¹H NMR) was measured under an applied magnetic field strength of 400 MHz with deuterated dimethyl sulfoxide (DMSO-*d*₆) as the solvent. The test results were: chemical shift δ = 8.31 (s, 3H); δ = 7.32-7.25 (m, 5H); δ = 5.53-5.48 (m, 1H); δ = 5.23 (s, 1H); and δ = 3.86-3.84 (m, 2H).

### (3) Synthesis of C3:

2-amino-3-phenylpropanol (10 mmol) was dissolved in ethanol (50 mL), the solution was cooled to 0°C, acetic acid (10 mmol) was added dropwise to the above solution, and the solution was stirred for 5 h. After the solvent was removed, recrystallization was performed in diethyl ether to obtain a compound C3 with a yield of approximately 91%. An H nuclear magnetic resonance spectrum (¹H NMR) was measured under an applied magnetic field strength of 400 MHz with deuterated dimethyl sulfoxide (DMSO-*d*₆) as the solvent. The test results were: chemical shift δ = 8.33 (s, 3H); δ = 7.23-7.19 (m, 5H); δ = 4.25-4.16 (m, 3H); δ = 3.97-3.93 (m, 1H); δ = 3.34-3.25 (m, 2H); and δ = 2.21 (s, 3H).

(4) Synthesis of C4: The synthesis route was the same as the synthesis of C2, except that 2-amino-1-phenylethanol was replaced with 2-dimethylamino-3-phenylpropionic acid. After reaction and purification, a compound C4 was obtained with a yield of approximately 51%. The ¹H NMR (400 MHz, DMSO-*d*₆) results were: δ = 12.72 (s, 1H); δ = 8.10 (s, 1H); δ = 7.22-7.18 (m, 5H); δ = 4.83-4.78 (m, 1H); δ = 3.37-3.31 (m, 2H); and δ = 2.86 (s, 6H).

(5) Synthesis of C5: The synthesis route was the same as the synthesis of C2, except that 2-amino-1-phenylethanol was replaced with 2-amino-3-(4-fluorophenyl)propanol. After reaction and purification, a compound C5 was obtained with a yield of approximately 35%. The ¹H NMR (400 MHz, DMSO-*d*₆) results were: δ = 8.31 (s, 3H); δ = 7.17-7.15 (m, 4H); δ = 4.33-4.28 (m, 2H); δ = 4.24 (s, 1H); δ = 3.99-3.95 (m, 1H); and δ = 3.27-3.21 (m, 2H).

(6) Synthesis of C6: 2-amino-3-(4-fluorophenyl)propanol (10 mmol) and anhydrous potassium carbonate (30 mmol) were dissolved in 20 mL of N,N-dimethylformamide, and iodomethane (35 mmol) was added dropwise. After stirring at 70°C for 12 h, the mixture was filtered, a supernatant was poured into 200 mL of diethyl ether, and the mixture was filtered to obtain a compound C6 with a yield of approximately 75%. The ¹H NMR (400 MHz, DMSO-*d*₆) results were: δ = 7.19-7.15 (m, 4H); δ = 4.25 (s, 1H); δ = 4.04-3.96 (m, 3H); δ = 3.30 (s, 9H); and δ = 3.07-3.01 (m, 2H).

(7) Synthesis of C7: The synthesis route was the same as the synthesis of C5, except that the aqueous solution (55%-57% by mass, 1.5 mL) of hydroiodic acid was replaced with an aqueous solution (50% by mass, 2 mL) of fluoroboric acid. After reaction and purification, a compound C7 was obtained with a yield of approximately 28%. The ¹H NMR (400 MHz, DMSO-*d*₆) results were: δ = 8.31 (s, 3H); δ = 7.17-7.15 (m, 4H); δ = 4.34-4.28 (m, 2H); δ = 4.23 (s, 1H); δ = 3.98-3.95 (m, 1H); and δ = 3.26-3.21 (m, 2H).

(8) Synthesis of C8: The synthesis route was the same as the synthesis of C2, except that 2-amino-1-phenylethanol was replaced with 2-amino-3-(3-trifluoromethylphenyl)propionic acid. After reaction and purification, a compound C8 was obtained with a yield of approximately 55%. The ¹H NMR (400 MHz, DMSO-*d*₆) results were: δ = 12.72 (s, 1H); δ = 8.31 (s, 3H); δ = 7.47-7.42 (m, 3H); δ = 7.21 (s, 1H); δ = 4.83-4.78 (m, 1H); and δ = 3.67-3.61 (m, 2H).

(9) Synthesis of C9: The synthesis route was the same as the synthesis of C2, except that 2-amino-1-phenylethanol was replaced with 3-(dimethylamino)-1-(2-thienyl)-1-propanol. After reaction and purification, a compound C9 was obtained with a yield of approximately 33%. The ¹H NMR (400 MHz, DMSO-*d*₆) results were: δ = 8.30 (s, 1H); δ = 7.53 (s, 1H); δ = 7.06-7.01 (m, 2H); δ = 5.18 (s, 1H); δ = 4.79-4.77 (m, 1H); δ = 3.24-3.20 (m, 2H); δ = 2.86 (s, 6H); and δ = 2.14-2.10 (m, 2H).

(10) Synthesis of C10: The synthesis route was the same as the synthesis of C2, except that 2-amino-3-(4-fluorophenyl)propanol was replaced with (S)-3-(dimethylamino)-1-(2-thienyl)-1-propanol. After reaction and purification, a compound C10 was obtained with a yield of approximately 31%. The ¹H NMR (400 MHz, DMSO-*d*₆) results were: δ = 8.30 (s, 1H); δ = 7.53 (s, 1H); δ = 7.06-7.01 (m, 2H); δ = 5.20 (s, 1H); δ = 4.79-4.77 (m, 1H); δ = 3.25-3.21 (m, 2H); δ = 2.86 (s, 6H); and δ = 2.14-2.10 (m, 2H).

(11) Synthesis of C11: The synthesis route was the same as the synthesis of C6, except that 2-amino-1-phenylethanol was replaced with (S)-3-(dimethylamino)-1-(2-thienyl)-1-propanol, the amount of potassium carbonate was reduced to 5 mmol, and the amount of iodomethane was reduced to 12 mmol. After reaction and purification, a compound C11 was obtained with a yield of approximately 71%. The ¹H NMR (400 MHz, DMSO-*d*₆) results were: δ = 7.53 (s, 1H); δ = 7.06-7.01 (m, 2H); δ = 5.32 (s, 1H); δ = 4.79-4.77 (m, 1H); δ = 3.24-3.20 (m, 2H); δ = 3.30 (s, 9H); and δ = 2.14-2.10 (m, 2H).

(12) Synthesis of C12: The synthesis route was the same as the synthesis of C2, except that 2-amino-1-phenylethanol was replaced with 3-(dimethylamino)-1-(2-thienyl)-1-propanol. After reaction and purification, a compound C12 was obtained with a yield of approximately 43%. The ¹H NMR (400 MHz, DMSO-*d*₆) results were: δ = 8.30 (s, 2H); δ = 7.53 (s, 1H); δ = 7.06-7.01 (m, 2H); δ = 4.79-4.77 (m, 1H); δ = 3.24-3.20 (m, 2H); δ = 2.86 (s, 3H); and δ = 2.14-2.10 (m, 2H).

(13) Synthesis of C13: The synthesis route was the same as the synthesis of C2, except that 2-amino-1-phenylethanol was replaced with 4-amino-3-(5-chloro-2-thienyl)butyric acid. After reaction and purification, a compound C13 was obtained with a yield of approximately 61%. The ¹H NMR (400 MHz, DMSO-*d*₆) results were: δ = 12.51 (s, 1H); δ = 8.30 (s, 3H); δ = 6.67-6.65 (m, 2H); δ = 3.73-3.58 (m, 3H); and δ = 2.61-2.57 (m, 2H).

(14) Synthesis of C14: The synthesis route was the same as the synthesis of C2, except that 2-amino-1-phenylethanol was replaced with 2-amino-3-(2-thienyl)propionic acid. After reaction and purification, a compound C14 was obtained with a yield of approximately 58%. The ¹H NMR (400 MHz, DMSO-*d*₆) results were: δ = 12.72 (s, 1H); δ = 8.32 (s, 3H); δ = 7.22 (d, J = 7.2Hz, 1H); δ = 6.92-6.90 (m, 2H); δ = 4.85-4.82 (m, 1H); and δ = 3.97-3.91 (m, 2H).

(15) Synthesis of C15: The synthesis route was the same as the synthesis of C1, except that 2-amino-3-phenylpropanol was replaced with (R)-3-amino-4-(2-thienyl)butyric acid. After reaction and purification, a compound C15 was obtained with a yield of approximately 63%. The ¹H NMR (400 MHz, DMSO-*d*₆) results were: δ = 12.03 (s, 1H); δ = 8.37 (s, 3H); δ = 7.38 (d, *J =* 7.2Hz, 1H); δ = 6.97-6.90 (m, 2H); δ = 4.30-4.26 (m, 1H); δ = 3.64-3.60 (m, 2H); and δ = 2.87-2.83 (m, 2H).

(16) Synthesis of C16: The synthesis route was the same as the synthesis of C1, except that 2-amino-3-phenylpropanol was replaced with (S)-3-amino-4-(2-thienyl)butyric acid. After reaction and purification, a compound C16 was obtained with a yield of approximately 68%. The ¹H NMR (400 MHz, DMSO-*d*₆) results were: δ = 12.04 (s, 1H); δ = 8.38 (s, 3H); δ = 7.37 (d, *J* = 7.2Hz, 1H); δ = 6.98-6.91 (m, 2H); δ = 4.30-4.27 (m, 1H); δ = 3.63-3.60 (m, 2H); and δ = 2.85-2.82 (m, 2H).

(17) Synthesis of C17: The synthesis route was the same as the synthesis of C2, except that 2-amino-1-phenylethanol was replaced with (R)-3-amino-4-(3-thienyl)butyric acid. After reaction and purification, a compound C17 was obtained with a yield of approximately 51%. The ¹H NMR (400 MHz, DMSO-*d*₆) results were: δ = 12.01 (s, 1H); δ = 8.33 (s, 3H); δ = 7.22 (d, *J =* 7.2Hz, 1H); δ = 6.92-6.90 (m, 2H); δ = 4.33-4.28 (m, 1H); δ = 3.43-3.39 (m, 2H); and δ = 3.06-3.02 (m, 2H).

(18) Synthesis of C18: The synthesis route was the same as the synthesis of C2, except that 2-amino-1-phenylethanol was replaced with (S)-3-amino-3-(2-thienyl)propionic acid. After reaction and purification, a compound C18 was obtained with a yield of approximately 57%. The ¹H NMR (400 MHz, DMSO-*d*₆) results were: δ = 12.51 (s, 1H); δ = 8.34 (s, 3H); δ = 7.22 (d, *J* = 7.2Hz, 1H); δ = 6.92-6.90 (m, 2H); δ = 5.23-5.19 (m, 1H); and δ = 3.26-3.21 (m, 2H).

(19) Synthesis of C19: The synthesis route was the same as the synthesis of C2, except that 2-amino-1-phenylethanol was replaced with 3-([2,2'-bithiophen]-5-yl)-2-aminomethyl-1-propanol. After reaction and purification, a compound C19 was obtained with a yield of approximately 21%. The ¹H NMR (400 MHz, DMSO-*d*₆) results were: δ = 8.31 (s, 1H); δ = 7.61 (d, *J =* 7.2Hz, 1H); δ = 7.51-7.47 (m, 2H); δ = 6.87-6.84 (m, 2H); δ = 4.26 (s, 1H); δ = 3.59-3.57 (m, 2H); δ = 3.39-3.35 (m, 2H); δ = 3.41-3.37 (m, 2H); and δ = 2.52-2.48 (m, 1H).

(20) Synthesis of C20: 3-bromo-2-(2-thienylmethyl)-1-amine (10 mmol) was dissolved in 20 mL of N,N-dimethylformamide, n-butylphosphine (PBu₃, 11 mmol) was added dropwise, reacted at 80°C for 12 h, then poured into diethyl ether, and filtered to obtain a compound C20 with a yield of approximately 58%. The ¹H NMR (400 MHz, DMSO-*d*₆) results were: δ = 7.38 (d, J = 7.2Hz, 1H); δ = 6.93-6.88 (m, 2H); δ = 4.25 (s, 1H); δ = 3.57-3.51 (m, 2H); δ = 2.87-2.77 (m, 2H); δ = 1.98-1.91 (m, 1H); δ = 1.45-1.27 (m, 20H); and δ = 0.93-0.88 (m, 9H).

### II. Fabrication of perovskite solar cell devices

### Example 1:

(1) 20 pieces of FTO conductive glass with specifications of 2.0 cm*2.0 cm were taken, and 0.35 cm of FTO was removed from two ends using laser etching to expose a glass substrate.
(2) The etched FTO conductive glass was ultrasonically cleaned sequentially with water, acetone, and isopropanol multiple times.
(3) The FTO conductive glass was dried with a nitrogen gun, and then further cleaned in an ultraviolet ozonizer.
(4) A surface of the FTO conductive glass was spin-coated with a methanol solution (10 mg/mL) of nano-nickel oxide at 2000 rpm, and the solvent was removed by vacuum or annealing to form a nickel oxide film (thickness of 30 nm).
(5) [4-(3,6-dimethyl-9H-carbazol-9-yl)butyl]phosphoric acid was dissolved in methanol (0.3 mg/mL) to obtain a self-assembled molecule solution, a surface of the nickel oxide film was spin-coated with the self-assembled molecule at 3000 rpm, and a self-assembled molecule layer (thickness of 5 nm) was obtained by vacuum or annealing.
(6) Lead iodide (726 mg), methylammonium iodide (240 mg), cesium iodide (19 mg), and lead bromide (11 mg) were weighed and dissolved in 1 mL of a mixed solution of DMF and DMSO (volume ratio 4:1), the solution was stirred for 3 h and filtered with a 0.22 µm organic filter membrane to obtain a perovskite precursor solution. The self-assembled molecule layer was spin-coated with the perovskite precursor solution at 3000 rpm, annealed at 100°C for 30 min, and cooled to room temperature, where an active material of a perovskite absorption layer was a CsFA system with a thickness of 800 nm.
(7) PC₆₁BM was dissolved in chlorobenzene (10 mg/mL), C1 was added to the above solution (0.1 mg/mL, doping amount of 1%), a perovskite layer was spin-coated with the solution at 1500 rpm to prepare an electron transport layer, annealed at 100°C for 10 min, with a thickness of 20 nm, and followed by spin-coating the blocking layer BCP at 5000 rpm, with a thickness of 5 nm.
(8) The semi-finished product obtained from the above steps was placed in an evaporator, a metal electrode Cu (thickness of 100 nm) was deposited to obtain a cell device labeled as Cell 1.

### Examples 2 to 5:

Based on Example 1, the method of adding an interface passivation material C1 was changed, the addition of C1 was removed in step (7).

The differences were as follows:
In Example 2, C1 was added to the perovskite precursor solution in step (6) (0.1 mg/mL, doping amount approximately 0.01%).
In Example 3, C1 was added to the methanol solution of the self-assembled molecule in step (5) (doping amount of 0.3%).
In Example 4, after the perovskite layer was prepared in step (6), the perovskite surface was spin-coated with an isopropanol solution (0.1 mg/mL, 30 µL) of C1 at 2000 rpm.
In Example 5, after the self-assembled molecule layer was prepared in step (5), the surface of the self-assembled molecule layer was spin-coated with an isopropanol solution (0.1 mg/mL, 30 µL) of C1 at 2000 rpm.

Examples 2 to 5 obtained cell devices labeled as Cells 2 to 5, respectively.

### Examples 6 to 24:

Based on Example 1, the type of interface passivation material was changed, with the difference being that in Examples 6 to 24, C1 was replaced with C2, C3, C4, C5, C6, C7, C8, C9, C10, C11, C12, C13, C14, C15, C16, C17, C18, C19, and C20, respectively. Examples 6 to 24 obtained cell devices labeled as Cells 6 to 24, respectively.

### Comparative Example 1:

Based on Example 1, the interface passivation material C1 was removed in step (7) to obtain a cell device labeled as Cell 25.

### Comparative Example 2:

Based on Example 1, C1 was replaced with D1 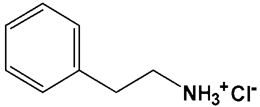 to obtain a cell device labeled as Cell 26.

### Comparative Example 2:

Based on Example 1, C1 was replaced with D2 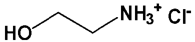 to obtain a cell device labeled as Cell 27.

### III. Testing of performance of perovskite solar cell devices

### (1) I-V measurement method:

The bias voltage points were varied and the current was simultaneously measured so as to obtain the I to V characteristics of the tested sample.
(a) A test fixture with a sample cell was placed on a sample holder to ensure that the fixture was within a measurement plane and that the sample cell was positioned at the center of the light spot emitted by a solar simulator (or that the normal of a photovoltaic cell was parallel to the centerline of a light beam emitted by the solar simulator).
(b) The solar simulator was from Enlitech that met the national standard IEC61215 for testing, the light intensity was calibrated with a crystalline silicon solar cell to achieve one sun intensity, and under an irradiance of 1000 W/m², a mask was applied to the tested sample cell, the temperature of the sample cell was controlled with a temperature monitoring device to maintain the temperature at (30±5°C) during measurement.
(c) The scanning direction, voltage range, scanning interval voltage, and scanning interval time were set. It is recommended that the scanning interval be no greater than 0.02 V, and the interval time between adjacent points be no less than 0.3s. The forward and reverse scan current-voltage characteristics of the tested sample cell were measured, and an open-circuit voltage V_{OC} and a short-circuit current J_{SC} were recorded.

Calculation formulas: Fill factor FF = Jₘ*Vₘ/V_{OC}*J_{SC}, and energy conversion efficiency PCE = V_{OC}*J_{SC}*FF/Pᵢₙ, where Pᵢₙ was the incident light intensity, which was equal to 10³ W/m².

The test results are shown in Table 1.

**Table 1: Test parameters for examples and comparative examples**

| | Interface passivation material | Addition method | Optimal efficiency (%) | Efficiency after 30 days (%) |
|---|---|---|---|---|
| Example 1 | C1 | In electron transport layer | 25.52 | 25.28 |
| Example 2 | C1 | In perovskite layer | 25.21 | 25.15 |
| Example 3 | C1 | In self-assembled molecule layer | 25.16 | 25 |
| Example 4 | C1 | At interface between perovskite layer and electron transport layer | 25.37 | 25.14 |
| Example 5 | C1 | At interface between hole transport layer and perovskite layer | 25.48 | 25.04 |
| Example 6 | C2 | In electron transport layer | 25.33 | 24.88 |
| Example 7 | C3 | In electron transport layer | 25.27 | 24.89 |
| Example 8 | C4 | In electron transport layer | 25.39 | 25.16 |
| Example 9 | C5 | In electron transport layer | 25.31 | 25.01 |
| Example 10 | C6 | In electron transport layer | 25.06 | 24.73 |
| Example 11 | C7 | In electron transport layer | 25.24 | 25.09 |
| Example 12 | C8 | In electron transport layer | 25.41 | 25.16 |
| Example 13 | C9 | In electron transport layer | 25.43 | 25.04 |
| Example 14 | C10 | In electron transport layer | 25.36 | 24.68 |
| Example 15 | C11 | In electron transport layer | 25.43 | 25.14 |
| Example 16 | C12 | In electron transport layer | 25.52 | 25.1 |
| Example 17 | C13 | In electron transport layer | 25.44 | 24.79 |
| Example 18 | C14 | In electron transport layer | 25.36 | 25.29 |
| Example 19 | C15 | In electron transport layer | 24.96 | 24.9 |
| Example 20 | C16 | In electron transport layer | 25.58 | 25 |
| Example 21 | C17 | In electron transport layer | 25.11 | 24.76 |
| Example 22 | C18 | In electron transport layer | 25.35 | 24.71 |
| Example 23 | C19 | In electron transport layer | 24.96 | 24.56 |
| Example 24 | C20 | In electron transport layer | 24.79 | 24.43 |
| Comparative Example 1 | None | In electron transport layer | 19.05 | 16.68 |
| Comparative Example 2 | D1 | In electron transport layer | 23.53 | 21.05 |
| Comparative Example 3 | D2 | In electron transport layer | 23.37 | 20.88 |

Note: The optimal efficiency is the highest efficiency of the device after 1 to 10 days of natural aging, and the efficiency after 30 days is the device efficiency of the device after storage in a nitrogen dark state.

### IV. Analysis of test results of performance of perovskite solar cell devices

As shown in Table 1, compared to the comparative example without the interface passivation material and the comparative examples with other interface passivation materials, the interface passivation materials of different types and addition methods in the examples of the present specification all improve the performance of perovskite solar cell devices. The optimal efficiency ranges from 24.79% to 25.58%, which is superior to 19.05% without the interface passivation material and 23.53% and 23.37% with other interface passivation materials. The efficiency after 30 days ranges from 24.43% to 25.29%, which is superior to 16.68% without the interface passivation material and 21.05% and 20.88% with other interface passivation materials.

In addition, the interface passivation materials of different types and addition methods in the examples of the present specification all improve the stability of perovskite solar cell devices, with minimal degradation in energy conversion efficiency after 30 days of storage, which is better than the comparative examples.

The foregoing descriptions are merely some embodiments of the present application, but are not intended to limit the patent scope of the present application. Any equivalent structural or process transformation made based on the content of the specification and accompanying drawings of the present application and any direct or indirect application in other related technical fields shall all fall within the patent protection scope of the present application in the same way.

## Claims

1. A solar cell, wherein the solar cell comprises an interface passivation material, the interface passivation material comprising a first compound represented by chemical formula (1) and/or a second compound represented by chemical formula (2): 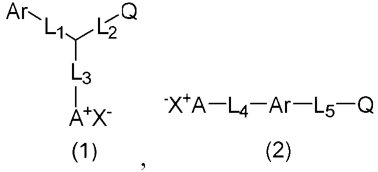
wherein, Ar is an aromatic group;
Q is a functional group containing active hydrogen;
A⁺ is selected from an ammonium group or a phosphonium group;
X⁻ is selected from any one of a halogen ion, a pseudohalogen ion, an oxyanion ion, a fluoroanion ion, or a sulfonyl imide anion; and
L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, wherein the heteroatom comprises one or more of a nitrogen atom, an oxygen atom, or a sulfur atom, and an alkylene chain with 0 carbon atoms indicates that two groups connected to L1 to L5 are directly connected.

2. The solar cell according to claim 1, wherein,
Q is selected from any one of a hydroxyl group (-OH), a carboxyl group (-COOH), a sulfhydryl group (-SH), an amino (-NR'H), or an amide group (-NHCOR); R' is selected from any one of a hydrogen atom, an alkyl chain with 1 to 10 carbon atoms, or a halogen-substituted alkyl chain with 1 to 10 carbon atoms; and R is selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, wherein the heteroatom comprises one or more of a nitrogen atom, an oxygen atom, or a sulfur atom.

3. The solar cell according to claim 1 or 2, wherein, in the first compound, Ar comprises any one of the following structures Ar1 to Ar15: 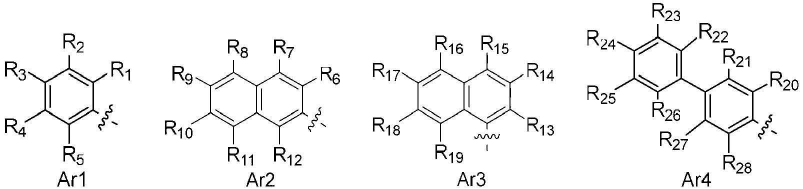 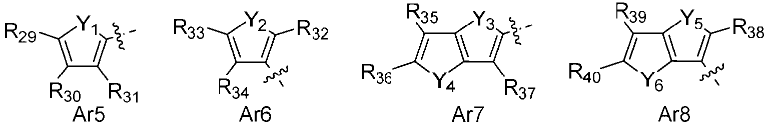 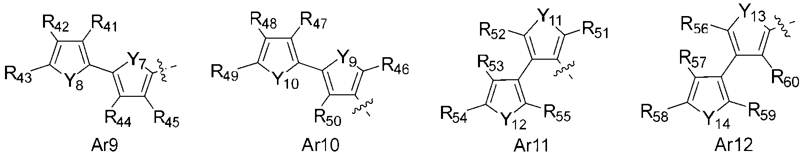 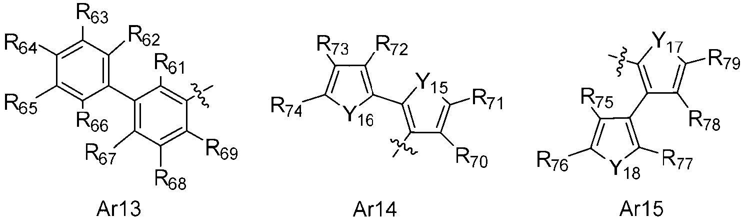
wherein, Y1 to Y18 are selected from any one of an oxygen atom (-O-), a sulfur atom (-S-), or an R'-substituted nitrogen atom (-NR'-); R' is selected from any one of a hydrogen atom, an alkyl chain with 1 to 10 carbon atoms, or a halogen-substituted alkyl chain with 1 to 10 carbon atoms; and R1 to R79 are selected from any one of a hydrogen atom, a halogen atom, an alkyl chain with 1 to 10 carbon atoms, a halogen-substituted alkyl chain with 1 to 10 carbon atoms, a heteroatom-containing chain with 1 to 10 carbon atoms, or a halogen-substituted heteroatom-containing chain with 1 to 10 carbon atoms, wherein the heteroatom comprises one or more of a nitrogen atom, an oxygen atom, or a sulfur atom;
wherein, 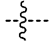 represents a single-bond attachment site, and when a structure of the interface passivation material is the formula (1), the structures Ar1 to Ar15 are connected to L1 through 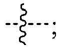 and/or in the second compound, Ar comprises any one of the following structures Ar16 to Ar30:
wherein, Ar16 differs from Ar1 in that any one of R1 to R5 is replaced by 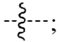 Ar17 differs from Ar2 in that any one of R6 to R12 is replaced by 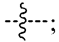 Ar18 differs from Ar3 in that any one of R13 to R19 is replaced by 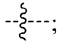 Ar19 differs from Ar4 in that any one of R20 to R28 is replaced by 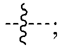 Ar20 differs from Ar5 in that any one of R29 to R31 is replaced by 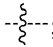 ; Ar21 differs from Ar6 in that any one of R32 to R34 is replaced by 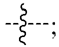 Ar22 differs from Ar7 in that any one of R35 to R37 is replaced by 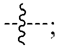 Ar23 differs from Ar8 in that any one of R38 to R40 is replaced by 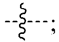 Ar24 differs from Ar9 in that any one of R41 to R45 is replaced by 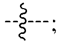 Ar25 differs from Ar10 in that any one of R46 to R50 is replaced by 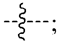 Ar26 differs from Ar11 in that any one of R51 to R55 is replaced by 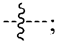 Ar27 differs from Ar12 in that any one of R56 to R60 is replaced by 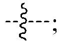 Ar28 differs from Ar13 in that any one of R61 to R69 is replaced by 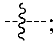 Ar29 differs from Ar14 in that any one of R70 to R74 is replaced by 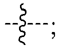 and Ar30 differs from Ar15 in that any one of R75 to R79 is replaced by 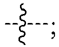 and
when the structure of the interface passivation material is the formula (2), the structures Ar16 to Ar30 are connected to L4 and L5, respectively, through

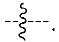

4. The solar cell according to any one of claims 1 to 3, wherein,
the ammonium group comprises -NR'₃⁺; and/or the phosphonium group comprises -PR'₃⁺;
wherein, R' is selected from any one of a hydrogen atom, an alkyl chain with 1 to 10 carbon atoms, or a halogen-substituted alkyl chain with 1 to 10 carbon atoms.

5. The solar cell according to any one of claims 1 to 4, wherein,
the halogen ion comprises any one of F⁻, Cl⁻, Br⁻, I⁻; and/or
the pseudohalogen ion comprises any one of CN⁻, OCN⁻, SCN⁻; and/or
the oxyanion ion comprises any one of NO₃⁻, ClO₃⁻, R"SO₃⁻, R"COO⁻, or R"PO₂(OH)⁻, wherein R" is selected from any one of a hydrogen atom, an alkyl chain with 1 to 10 carbon atoms, a halogen-substituted alkyl chain with 1 to 10 carbon atoms, Ar1 to Ar15, or an alkyl chain with 1 to 10 carbon atoms substituted with Ar1 to Ar15; and/or
the fluoroanion ion comprises any one of BF₄⁻ or PF₆⁻; and/or
the sulfonyl imide anion comprises (CF₃SO₂)₂N⁻.

6. The solar cell according to any one of claims 1 to 5, wherein,
the interface passivation material comprises any one of the following structures C1 to C27:

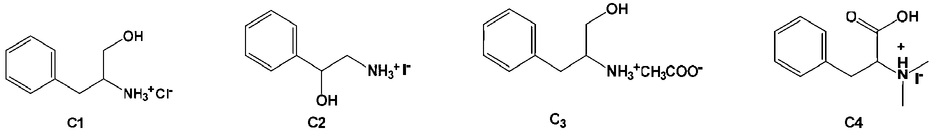

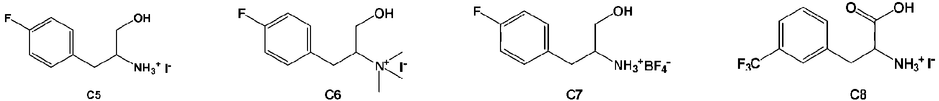

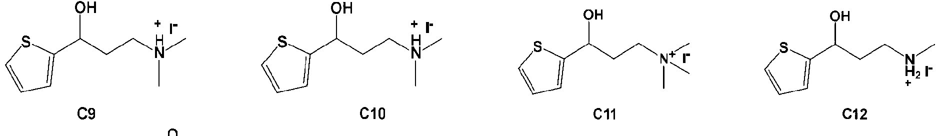

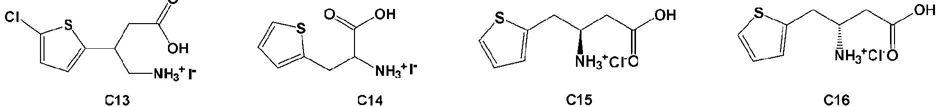

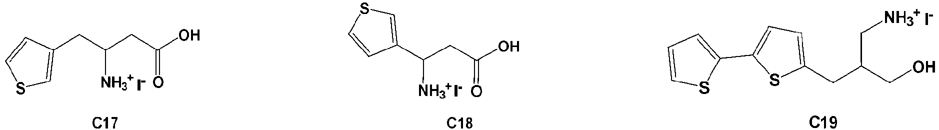

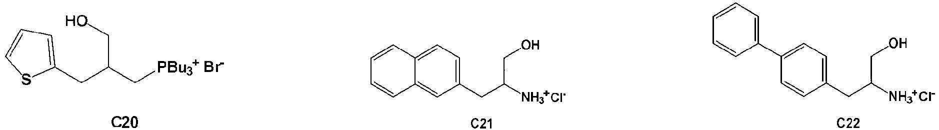

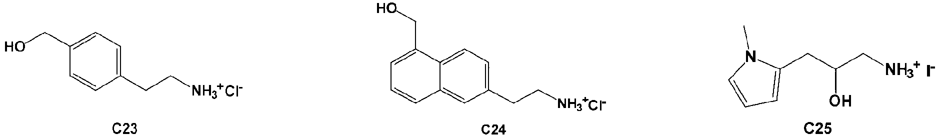

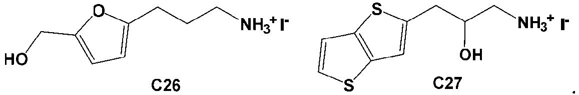

7. The solar cell according to any one of claims 1 to 6, wherein, the solar cell comprises a first electrode, a first transport layer, a light absorption layer, a second transport layer, and a second electrode that are sequentially stacked; and
the interface passivation material is distributed in one or more layers of the first transport layer, the light absorption layer, or the second transport layer.

8. The solar cell according to claim 7, wherein,
based on a total mass of a doped base layer, a doping ratio of the interface passivation material is 0.005% to 5%, and the doped base layer is any one of the first transport layer, the light absorption layer, or the second transport layer.

9. The solar cell according to any one of claim 7 or 8, wherein,
the first transport layer is an electron transport layer, and the second transport layer is a hole transport layer, or
the first transport layer is a hole transport layer, and the second transport layer is an electron transport layer.

10. The solar cell according to any one of claims 1 to 6, wherein,
the solar cell comprises a first electrode, a first transport layer, a light absorption layer, a second transport layer, and a second electrode that are sequentially stacked, and the solar cell further comprises a passivation layer, wherein the interface passivation material is distributed in the passivation layer;
the passivation layer is located between the first transport layer and the light absorption layer, and/or
the passivation layer is located between the second transport layer and the light absorption layer.

11. The solar cell according to claim 10, wherein,
a thickness of the passivation layer is 0.1 nm to 10 nm.

12. The solar cell according to claim 10 or 11, wherein,
the first electrode, the first transport layer, the light absorption layer, the second transport layer, and the second electrode are sequentially arranged from bottom to top from a light incident surface of a substrate layer, the first transport layer is a hole transport layer, the second transport layer is an electron transport layer, the light absorption layer comprises a perovskite material, and the passivation layer is located between the electron transport layer and the light absorption layer.

13. The solar cell according to claim 9 or 12, wherein,
a material of the first electrode comprises any one of fluorine-doped tin oxide, indium tin oxide, aluminum-doped zinc oxide, boron-doped zinc oxide, or indium-doped zinc oxide; and/or
the light absorption layer comprises a perovskite material, the perovskite material comprising any one of ABX₃, A₂CDX₆, wherein A is any one of an inorganic cation, an organic cation, or an organic-inorganic hybrid cation, optionally at least one of a methylammonium ion, an n-butylammonium ion, or a cesium ion; B is any one of an inorganic cation, an organic cation, or an organic-inorganic hybrid cation, optionally at least one of a lead ion or a tin ion; C is any one of an inorganic cation, an organic cation, or an organic-inorganic hybrid cation, optionally a silver ion; D is any one of an inorganic cation, an organic cation, or an organic-inorganic hybrid cation, optionally at least one of a bismuth ion, an antimony ion, or an indium ion; and X is any one of an inorganic anion, an organic anion, or an organic-inorganic hybrid anion, optionally at least one of a bromide ion or an iodide ion; and/or
a material of the electron transport layer comprises at least one of [6,6]-phenyl-C₆₁-butyric acid methyl ester (PC₆₁BM), [6,6]-phenyl-C₇₁-butyric acid methyl ester (PC₇₁BM), fullerene C₆₀(C₆₀), fullerene C₇₀(C₇₀), tin dioxide (SnO₂), zinc oxide (ZnO), a perylene diimide (PDI)-based material, a naphthalene diimide (NDI)-based material, a derivative thereof, or a material obtained by doping or passivation thereof; and/or
a material of the hole transport layer comprises one or more of a metal oxide material, a polymer material, an organic small molecule self-assembled molecular material, a derivative thereof, or a material obtained by doping or passivation thereof, optionally one or more of nickel oxide (NiOₓ₂, 1≤x2≤1.5), molybdenum oxide (MoOₓ₃, 2.5≤x3≤3), tungsten oxide (WOₓ₃), poly[bis(4-phenyl)(2,4,6-trimethylphenyl)amine] (PTAA), poly(3,4-ethylenedioxythiophene)-poly(styrenesulfonate) (PEDOT:PSS), or carbazole or a triphenylamine-based material containing phosphate or a carboxylic acid group; and/or
an electrode material of the second electrode comprises one or more of an organic conductive material, an inorganic conductive material, or an organic-inorganic hybrid conductive material, optionally one or more of silver, copper, carbon, gold, aluminum, indium tin oxide, aluminum-doped zinc oxide, boron-doped zinc oxide, or indium-doped zinc oxide.

14. The solar cell according to claim 13, wherein,
a thickness of the first electrode is 10 nm to 1000 nm; and/or
the light absorption layer comprises a perovskite material, the perovskite material has a bandgap of 1.20 eV to 2.30 eV, and a thickness of the light absorption layer is 200 nm to 1000 nm; and/or
a thickness of the electron transport layer is 5 nm to 100 nm; and/or
a thickness of the hole transport layer is 0.5 nm to 50 nm; and/or
a thickness of the second electrode is 10 nm to 1000 nm.

15. The solar cell according to claim 13 or 14, wherein, the solar cell further comprises a blocking layer, the blocking layer being located between the electron transport layer and the first electrode, or the blocking layer being located between the electron transport layer and the second electrode; and
a material of the blocking layer comprises one or more of 2,9-dimethyl-4,7-diphenyl-1,10-phenanthroline, tin dioxide, zinc oxide, or cerium oxide, wherein the chemical formula of cerium oxide is CeOₓ₁, and 1.5≤x1≤2, and a thickness of the blocking layer is 0.5 nm to 200 nm.

16. An interface passivation material, wherein the interface passivation material comprises a first compound represented by chemical formula (1) and/or a second compound represented by chemical formula (2): 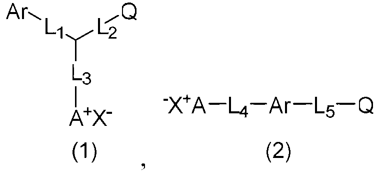
wherein, Ar is an aromatic group;
Q is a functional group containing active hydrogen;
A⁺ is selected from an ammonium group or a phosphonium group;
X⁻ is selected from any one of a halogen ion, a pseudohalogen ion, an oxyanion ion, a fluoroanion ion, or a sulfonyl imide anion; and
L1 to L5 are selected from any one of an alkylene chain with 0 to 10 carbon atoms, a halogen-substituted alkylene chain with 0 to 10 carbon atoms, a heteroatom-containing chain with 0 to 10 carbon atoms, a halogen-substituted heteroatom-containing chain with 0 to 10 carbon atoms, or a single heteroatom, wherein the heteroatom comprises one or more of a nitrogen atom, an oxygen atom, or a sulfur atom, and an alkylene chain with 0 carbon atoms indicates that the two groups connected to L1 to L5 are directly connected.

17. A photovoltaic power generation system, wherein the solar cell according to any one of claims 1 to 15 is comprised.

18. An electric device, wherein the solar cell according to any one of claims 1 to 15 is comprised.
